**Europäisches Patentamt**

**European Patent Office**

**Office européen des brevets**

(19)

(11) Veröffentlichungsnummer : **0 262 088 B1**

(12) **EUROPÄISCHE PATENTSCHRIFT**

(45) Veröffentlichungstag der Patentschrift :
05.06.91 Patentblatt 91/23

(51) Int. Cl.⁵ : **H01L 23/00, B23K 26/02, G06K 7/015**

(21) Anmeldenummer : **87810500.6**

(22) Anmeldetag : **01.09.87**

(54) Anordnung zur Positionierung und Synchronisation eines Schreiblaserstrahls.

(30) Priorität : 22.09.86 CH 3781/86

(43) Veröffentlichungstag der Anmeldung :
30.03.88 Patentblatt 88/13

(45) Bekanntmachung des Hinweises auf die
Patenterteilung :
05.06.91 Patentblatt 91/23

(84) Benannte Vertragsstaaten :
AT BE CH DE ES FR GB GR IT LI LU NL SE

(56) Entgegenhaltungen :
EP-A- 0 066 835
EP-A- 0 168 351
JO-U-RN AL OF
US-A- 4 134 066

(56) Entgegenhaltungen :
IBM TECHNICAL DISCLOSURE BULLETIN,
Band 25, Nr. 3B, August 1982, Seiten
1377-1378, New York, US; D.R. GRUIDEL et al.:
"Variable grid detection"

(73) Patentinhaber : Lasarray Holding AG
CH-8512 Thundorf (CH)

(72) Erfinder : Kempter, Meinrad
Tulpenweg 16
CH-3250 Lyss (CH)
Erfinder : Doering, Elko
Alte Bielstrasse 3
CH-2572 Mörigen (CH)

(74) Vertreter : Frauenknecht, Alois J. et al
c/o PPS Polyvalent Patent Service AG,
Mellingerstrasse 1
CH-5400 Baden (CH)

## Beschreibung ·

Die vorliegende Erfindung bezieht sich auf eine Anordunung aufeinern Chip zur Positionierung und Synchronisation eines Schreiblaserstrahls auf dem Chip bei einem Laserschreibverfahren mittels eines Laser-Pattern-Generators, wobei im Randbereich des Chips auf der Oberfläche Erkennungsmuster für einen Tastlaserstrahl vorgesehen sind, die den Tastlaserstrahl in bezug auf andere Teile der Oberfläche des Chips unterschiedlich stark reflektieren.

In der EP-A1-0 088 045 ist ein Verfahren zur Herstellung elektrisch leitender Bereiche in integrierten monolythischen Halbleiteranordnungen sowie danach hergestellte Halbleiteranordnung hoher Packungsdichte enthalten. Bei der Herstellung kundenspezifischer integrierter Schaltungen werden handelsübliche Silizumscheiben mit P- und N- resp. N- und P-Strukturen verwendet, auf welchen je nach Verwendungszweck spezifische Kontaktflächen zur Verbindung dieser Strukturen erzeugt werden. Auf dem vorfabrizierten Chip befinden sich eine leitende Schicht und vorfabrizierte Aussparungen, die gemäss dem Programm so mit Hilfe eines Schreiblaserstrahls durch linienförmiges Abtragen verbunden werden, so dass die Aussparungen Verbindungs-, End- und/oder Eckpunkte insularer Bereiche bilden. Die insularen Bereiche sind mit entsprechenden Kontaktflächen und Strukturen elektrisch leitend verbunden.

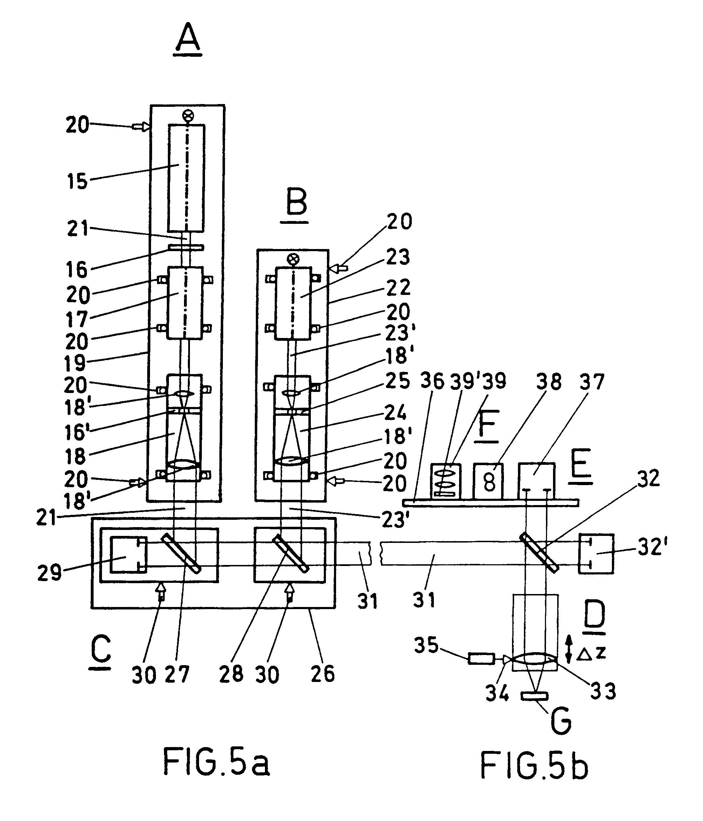

In der EP-A1-0 168 351 ist ein Laser-Pattern-Generator und ein Verfahren zu dessen Betrieb beschrieben und dargestellt. Dieser Laser-Pattern-Generator enthält ein Laser-Gerät für die Erzeugung eines Schreiblaserstrahls und ein Laser-Gerät für die Herstellung eines Tastlaserstrahls. Mit dem Tastlaserstrahl wird über eine in der Druckschrift näher beschriebene Elektronik die Oberfläche des Chips abgetastet und in bezug auf die verschieden starke Reflektion mit wenigstens einem Detektor ausgewertet und dann mittels einer Logikvorrichtung die gegenseitige Bewegung des Schreiblaserstrahls und des Chips gesteuert. Dieses Verfahren und der entsprechende Laser-Pattern-Generator werden später anhand der Fig. 5a und 5b näher erläutert.

Aus der US-A 4 134 066 ist bekannt, zur Kennzeichnung der Position von Artifakten und hefehten in der logik auf dem Chip ein Erkennungsmauter einer Code-Systems an zubringen.

Die Aufgabe der Erfindung besteht darin, eine Anordnung der eingangs genannten Art so auszubilden, dass die Positionierung und Synchronisation noch präzisere Ansprüche erfüllen kann und dass auch die Bearbeitungsgeschwindigkeit weiter gesteigert werden kann.

Die vorgenannte Aufgabe wird bei einer Anordnung der eingangs genannten Art dadurch gelöst, dass sich der Erkennungsmurke eine erstes Eintrittscodes mit einer Synchronisationsstruktur und einer Schritterkennungsstruktur entlang von wenigstens zwei Rändern des Chips auf seiner Oberfläche erstreckt. In dieser Reihe des ersten Eintrittscodes ist also eine Synchronisationsstruktur und eine danach folgende Schritterkennungsstruktur enthalten, wobei diese zwei Strukturen die entsprechenden Informationen für die Auswertung des reflektierten Tastlaserstrahls geben.

Nach einer zweckmässigen Weiterbildung erstreckt sich auf der Oberfläche des Chips senkrecht zu der Längsrichtung des ersten Eintrittscodes ein Einfädelcode in der Richtung zu einer Ecke eines Rahmens mit einer Logik. Dieser Einfädelcode sichert, dass der Weg des Schreiblaserstrahls in der entsprechenden Ecke der Logik beginnt.

Es ist vorteilhaft, wenn der die Logik umfassende Rahmen mit je einem zweiten Eintrittscode versehen ist. Dieser zweite Eintrittscode dient auch zur präzisen koaxialen Einstellung des Schreiblaserstrahls zum Tastlaserstrahl am Ort der Logik.

Zweckmässig erstreckt sich der zweite Eintrittscode auf der äusseren Randzone des Rahmens parallel mit dem je entsprechenden ersten Eintrittscode. Dieser zweite Eintrittscode, in der Nähe der Kernstruktur (sogenanntes Gatterfeld), erlaubt damit eine optimale Feinkorrektur der Synchronisation.

Das Verfahren zur gegenseitigen Positionierung und Synchronisation des Schreiblaserstrahls und des Chips besteht zweckmässig darin, dass mit je einem Tastlaserstrahl der erste Eintrittscode und/oder der Einfädelcode und/oder der zweite Eintrittscode abgetastet wird, dass der reflektierte, von der Oberfläche des Chips beeinflusste Tastlaserstrahl mit wenigstens einem Detektor empfangen und danach ausgewertet wird und dass aufgrund der Auswertung die gegenseitige Bewegung des Chips und des Schreiblaserstrahls nach einem vorgegebenen Muster gesteuert und eventuell korrigiert wird. Es ist also ersichtlich, dass vorteilhaft alle drei Arten von Codes ausgenützt werden, obwohl dies nicht immer notwendig ist. Mit diesem Verfahren wird eine Referenz durch eine Kopplung eines "äusseren" vorgegebenen Musters zu einem "inneren" Muster des Chips gesichert.

In bezug auf die Ausnutzung der Optik ist es zweckmässig, wenn der Tastlaserstrahl im Bereich der Chip-Oberfläche koaxial mit dem Schreiblaserstrahl geführt wird.

Es ist selbstverständlich auch möglich, dass der Tastlaserstrahl im Bereich der Chips-Oberfläche vor dem Schreiblaserstrahl geführt wird. Bei diesem Verfahren wird selbstverständlich die Information früher erreicht, so dass mehr Zeit bleibt, eventuelle Korrekturen der relativen Bewegung des Schreiblaserstrahls und des Chips zu realisieren.

Die Erfindung wird anhand eines Beispiels näher erläutert.

Gleiche Teile sind in allen Zeichnungen mit denselben Bezugsziffern versehen.

Es zeigen :

Fig. 1 eine schematische Ansicht auf eine Ecke der erfindungsgemässen Anordnung mit einer charakteristischen Peripherie-Struktur und einer angedeuteten Kernstruktur,

Fig. 2 bis

Fig. 4 die vergrösserten Details II-IV aus der Fig. 1,

Fig. 5a und

Fig. 5b schematische Darstellung des an sich bekannten Laser-Pattern-Generators aus der EP-A1-0 168 351, mit dem das erfindungsgemässe Verfahren zweckmässig realisiert werden kann.

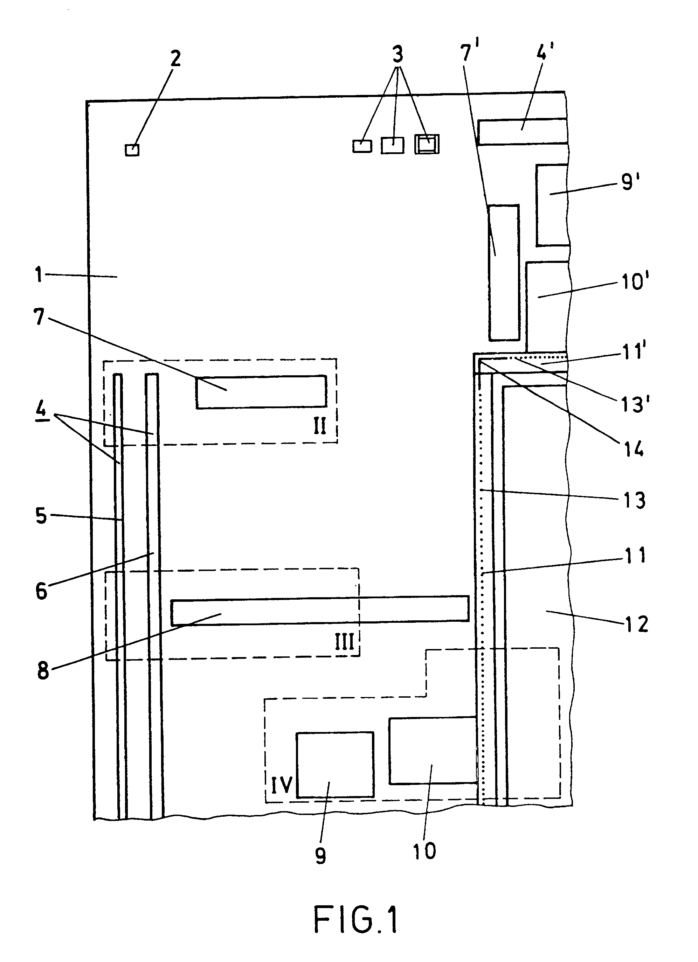

Fig. 1 zeigt einen Chip 1, auf dessen Oberfläche sich eine Justierstruktur 2 und mehrere Justierelemente 3 befinden. Entlang der Kante des Chips 1 erstreckt sich ein erster Eintrittscode 4. In der oberen Ecke rechts ist ein Teil eines anderen ersten Eintrittscodes 4' gezeigt, der sich parallel mit einer anderen Kante des Chips 1 erstreckt. Der erste Eintrittscode 4 besteht aus zwei parallel verlaufenden Strukturen und zwar aus einer Synchronisationsstruktur 5 und einer Schritterkennungsstruktur 6. Die Aufgaben dieser Strukturen sind schon durch ihre Bezeichnung gegeben. Senkrecht zur der Längsrichtung des ersten Eintrittscodes 4 erstreckt sich in der Richtung zu einer Ecke 14 eines Rahmens 11, 11' mit einer Logik 12 ein Einfädelcode 7. Ein anderer Einfädelcode 7' erstreckt sich senkrecht zur Längsrichtung des anderen ersten Eintrittscode 4'. Ebenfalls senkrecht zum ersten Eintrittscodes 4 verläuft ein Beschriftungsfeld 8, das meistens in Blockrasterschrift hergestellt ist und die Kundenbezeichnung, eventuell den Typ, enthalten kann. Im unteren Teil der Fig. 1 ist eine Anschlussschaltung 9 genannt PAD 9, welche in der oberen rechten Ecke einer anderen Anschlussschaltung 9' entspricht. Mit diesen Anschlussschaltungen 9, 9' sind entsprechende Eingangs- und Ausgangsstrukturen 10, 10' verbunden, die dann selbstverständlich an den Rahmen 11, 11' angeschlossen sind. Auf diesem Rahmen 11, 11' befindet sich ein zweiter Eintrittscode 13, der sich parallel mit dem ersten Eintrittscode 4 erstreckt und ein anderer, zweiter Eintrittscode 13', der parallel mit dem anderen ersten Eintrittscode 4' liegt.

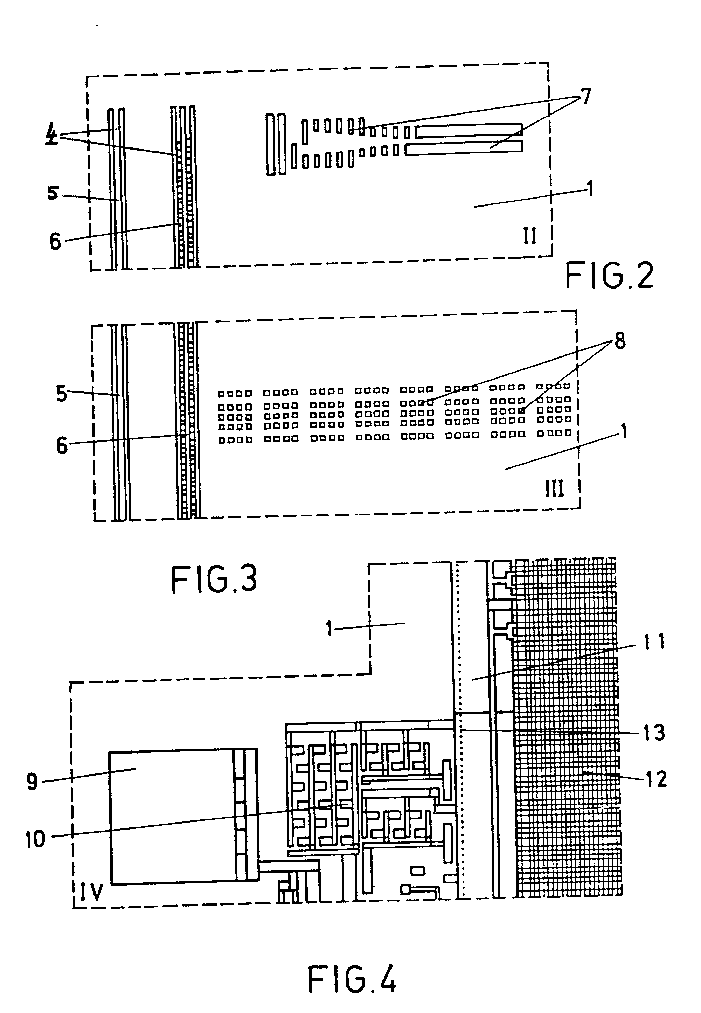

In der Fig. 2 ist das Detail II aus der Fig. 1 dargestellt. Dieses vergrösserte Detail enthält den oberen Teil des ersten Eintrittscodes 4 mit seiner Synchronisationsstruktur 5 und seiner Schritterkennungsstruktur 6 und die Aufsicht auf den Einfädelcode 7. Der erste Eintrittscode 4 gibt die Bearbeitungsinformationen, und der Einfädelcode 7 führt den Tastlaser- und Schreiblaserstrahl 21, 23' in der genauen Richtung zum Anfang der zu bearbeitenden Logik 12.

Die Fig. 3 zeigt weitere zwei Ausschnitte der Synchronisationsstruktur 5 und der Schritterkennungsstruktur 6. Dazu ist schematisch dargestellt ein Teil des Beschriftungsfeldes 8, dessen Aufgabe schon oben beschrieben wurde.

Die vergrösserten Details gemäss der Fig. 4 zeigen wiederum die Peripherie-Struktur (PAD-Feld) und rechtsseitig die Kernstruktur mit ihrer Logik. Es sind schematische Darstellungen der Anschlussschaltung 9 und der dazu gehörigen Eingangs- und Ausgangsstruktur 10 ersichtlich. Diese Eingangs- und Ausgangsstruktur 10 ist an den Rahmen 11 angeschlossen und weiter mit der im Rahmen 11 sich befindenden Logik 12 elektrisch verbunden. Am Rande des Rahmens 11 befindet sich der zweite Eintrittscode 13.

Die Fig. 5a und 5b zeigen eine schematische Darstellung des an sich bekannten Laser-Pattern-Generators gemäss der EP-A1-0 168 351. Mit diesem Generator kann man sehr vorteilhaft das früher beschriebene Verfahren realisieren und die oben beschriebenen Chips bearbeiten. Gemäss Fig. 5a sind die Schreiblaserstrahlquelle A und die Tastlaserstrahlquelle B parallel mit optischen Achsen in horizontaler Lage angeordnet. Die Schreiblaserstrahlquelle A enthält ein Schreiblasergerät 15, hinter welchem sich ein Laserstrahlschalter 16 zum Ausschalten des Schreiblaserstrahls 21 bei offenem Gerät befindet. Eine Lochblende 16' ist in einem Aufweiter 18 des Schreiblasergeräts 15 angeordnet. Zwischen diesen Bestandteilen befindet sich in der optischen Achse ein Modulator 17. Linsen des Aufweiters 18 sind mit der Ziffer 18' bezeichnet und die ganze Schreiblaserstrahlquelle A ist in einem Gehäuse 19 gelagert. Der Modulator 17 und der Aufweiter 18 sind mit einstellbaren Befestigungselementen 20 im genannten Gehäuse 19 gehalten. Das ganze Gehäuse 19 ist ebenfalls mit einstellbaren Befestigungselementen 20 versehen, die ermöglichen, die optische Achse dieser Schreiblaserstrahlquelle A richtig zu ordnen. Der Schreiblaserstrahl ist mit Bezugsziffer 21 bezeichnet. Die Tastlaserstrahlquelle B ist in einem Gehäuse 22 gelagert. Sie enthält ein Tastlasergerät 23, aus welchem ein Tastlaserstrahl 23' in den Aufweiter 24 der Tastlaserstrahlquelle B geleitet ist. Auch dieser Aufweiter 24 enthält zusätzlich zu den schon erwähnten Linsen 18' eine Lochblende 25. Die Tastlaserstrahlquelle B enthält auch weitere Elemente, die schon bei der Beschreibung der Schreiblaserstrahlquelle A erwähnt wurden.

Aus dem Tastlasergerät 23 wird ein Tastlaserstrahl 23' in den Aufweiter 24 geführt. Die Bestandteile der Tastlaserstrahlquelle B sind in einem Gehäuse 22 gelagert, das gleich wie das Gehäuse 19 der Schreiblaserstrahlquelle A mit einstellbaren Befestigungslementen 20 in die richtige Position gebracht werden kann. In der Richtung der optischen Achsen des Schreiblaserstrahls 21 und des Tastlaserstrahls 23' befindet sich ein Laserstrahlensammler C. Dieser enthält in einem Gehäuse 26 einen Schreiblaserstrahlteiler 27 und ·einen Tastlaserstrahlspiegel 28, die in der Fig. 5a in Draufsicht dargestellt sind. Diese Elemente sind einstellbar mittels Einstellelementen 30 im genannten Gehäuse 26 gelagert. Links vom Schreiblaserstrahlteiler 27 befindet sich ein Schreiblaserstrahldetektor 29, der die richtige Ausgangslage des Schreiblaserstrahls 21 kontrolliert. Der reflektierte Schreiblaserstrahl 21 und der reflektierte Tastlaserstrahl 23' verlaufen auf ein und derselben Achse 31, die dann direkt in die Fig. 5b führt. Diese Fig. 5b weist eine vertikale optische Achse auf. Der gemeinsame Strahlengang 31 fällt zuerst auf einen Tastlaserstrahlteiler 32. Von diesem geht der überwiegende Teil der Strahlung in das Objektiv 33 des Objektivkopfes D und weiter auf das Werkstück-Wafer G. In der Richtung der auf derselben Achse geführten Schreib- und Tastlaserstrahlen 31 befindet sich hinter dem Tastlaserstrahlteiler 32 ein Detektor 32'. Die Aufgabe dieses Detektors 32' ist, den richtigen Strahlengang 31 zu überwachen. Das Objektiv 33 weist Einstellelemente 34 auf, die mit einem piezoelektrischen Antrieb 35 versehen sind. Direkt oberhalb des Objektivkopfes D ist ein Revolverkopf E drehbar angeordnet, wobei dieser Objektivkopf D und der Revolverkopf E eine funktionelle Einheit, ein Optikmodul F bilden. Der Objektivkopf E enthält im wesentlichen einen Revolverhalter 35, auf dem sich drehbar in diesem Beispiel ein Tastlaserstrahldetektor 37, ein Scherungs-Interferometer Okular 38 (shearing-interferometer) und ein Mikroskopokular 39 mit Fadenkreuz befinden. Dieses Mikroskopokular 39 ist aus Sicherheitsgründen mit einem Schreiblasersperrfilter 39' versehen.

In der Zeichnung 5b ist aus Übersichtlichkeitsgründen der Revolverkopf E in einer entwickelten, also geradlinigen Form gezeichnet.

In dieser beispielsweisen Ausführungsform wurde als das Schreiblasergerät 15 ein natürlich luftgekühltes Helium-Cadmium Lasersystem verwendet. Dieses Lasergerät besteht aus einem stromgeregelten Hochspannungsspeisegerät mit Kalt- und Warmstart, mit Zeitprogramm und Zündsteuerung, sowie aus einem Laser. Die Hauptmerkmale des Schreiblasergerätes 15 sind folgende : Lichtwellenlänge 442 nm, Lichtleistung 10 mW (Dauerlicht), die Intensität ist normal über den Srahldurchmesser verteilt, Polarisations-Richtung ist horizontal +−5%, Strahldurchmesser 1,1 mm.

Das Tastlasergerät 23 ist ein nätürlich luftgekühltes Helium-Neon-Lasersystem. Die Lichtwellenlänge beträgt 633 nm, Lichtleistung ist 1mW, Abweichung der Strahlachse nach dem Kaltstart ist < 200 µRad, nach 15 Min. Betrieb 30 µRad. Die Strahl-Divergenz ist < 1,3 mRad, Regelabweichung der Lichtleistung ist <+−5%.

Der Modulator 17 ist ein natürlich luftgekühltes, elektrisch gesteuertes Kohärent-Blaulaserlicht-Unterbrecher-System. Das Modulator-Rohr enthält einen bruchempfindlichen, in Flüssigkeit mit gleicher Brechungszahl eingebettetem Kaliumdihydrogenphosphat-Kristall mit zwei Steuerelektroden und einem am Ausgang angebauten Fotodioden Lichtmesser. Der Kristall wirkt als Polarisationsfilter, dessen Richtungswinkel mit einer Spannung von ca. 600 V über 90 Grad gedreht werden kann.

Der Aufweiter 18 besteht aus zwei Sammellinsen und einer Lochblende, die auch "pinhole" genannt wird, mit einem Durchmesser von 10 Mikrometer, im gemeinsamen Brennpunkt der Sammellinsen. Der Aufweiter vergrössert den Durchmesser und verkleinert die Divergenz des Laserstrahls im Aufweitungsverhältnis, das ist das Verhältnis der Brennpunktabstände, und überträgt das Bild des Lichtpunktes in der Lochblende im Ausgangsstrahl, d.h. entfernt z.B. wegen Staub entstandene dunkle Punkte des ankommenden Laserstrahls und macht die Richtung des Ausgangstrahls unabhängig von der Richtung des Eingangsstrahls.

Als Teiler 27 wird ein dichroitischer Teiler verwendet, der aus einer planparallelen Glasplatte mit einseitig aufgedampfter dielektrischer Metallschicht besteht. Dieser lässt das Licht der bestimmten Wellenlänge, d.h. der einen Farbe, das in der Durchgangsrichtung eintrifft, in der gleichen Richtung durch, versetzt dabei den Strahlungsaustrittspunkt abhängig von der Brechungszahl des Glases für die bestimmte Wellenlänge in Abhängigkeit von der Dicke des Glases.

Ein Mikroskop besteht aus dem Objektiv 33 und dem Mikroskopokular 39. Das Objekt 33 weist ein Sammellinsensystem mit oder ohne Standard-Deckglas auf der Arbeitsseite auf, fokussiert den konzentrisch und parallel eintretenden blauen und roten Laserstrahl zum kleinstmöglichen Brennfleck im Arbeitsabstand, leitet ein vergrössertes Luftbild des konzentrisch zum Brennfleck liegenden grün beleuchteten Bildfeldes ab, das mit dem Mikroskopokular 39 betrachtet werden kann. Es setzt die mechanische Verschiebung durch den piezoelektrischen Antrieb 35 in eine Verschiebung des Bild- und Brennfleck-Mittelpunktes um. Es werden damit die erforderlichen Einstellungen in Richtung Z um Delta Z und in Y-Richtung um Delta Y vorgenommen. Der Verschiebungsbereich um Delta Z ist durch einen Pfeil markiert ; derjenige um Delta Y befindet sich orthogonal dazu.

Das Mikroskopokular 39 ist als ein Sammellinsensystem mit der Funktion einer Lupe ausgebildet und leitet aus dem Luftbild des Objektives 33 ein vergrössertes sichtbares Bild ab.

Der Scherungs-Interferometer besteht aus einem in den Strahlengang einschiebbaren Spiegel, einer planparallelen Glasplatte und einem Okular 38, bildet ein Scherungs-Interferometer zum Messen der Abweichung des Abstandes der reflektierenden Aluminium-Fläche von der Fokussierebene des Objektivs 33.

Die Detektoren 29, 32' und 37 bestehen zweckmässig aus je einer zentralen, inneren unempfindlicheren und einer äusseren empfindlicheren Anordnung von Silizium-Photodioden. Sie leiten aus dem vom Werkstück reflektierten oder auf eine andere Weise gewonnenen Laserstrahl die Feststellung ab, ob sich der zuständige Laserstrahl in der richtigen Lage befindet oder in einer bestimmten Richtung sich von dieser Lage entfernt.

Das Schreiblasergerät 15 ist in den letztgenannten Beispielen z.B. ein Argonionenlaser von 1 bis 5 mW Leistung bei 458 nm Wellenlänge, oder ein He-Cd-Laser von 7 bis 40 mW Leistung bei 442 nm, oder 1 bis 10 mW bei 325 nm.

Auch das Schalten der kontinuierlichen Laserleistung wird mit einem elektrooptischen Modulator – Strahlschalter 17 oder einem akustooptischen Modulatorm – Strahlschalter durchgeführt. Die benötigte Schaltzeit ergibt sich aus der Schreibgeschwindigkeit und der örtlichen Auflösung und ist z.B. 2 Mikrosec. Der nachfolgende Strahlaufweiter 18 erhöht den Strahldurchmesser z.B. auf das Zehnfache. Der horizontale Schreibstrahl wird in vertikaler Richtung umgelenkt mit dem Umlenkspiegel. Das Objektiv 33 besitzt in diesem Beispiel eine Brennweite von 18 mm und einen Durchmesser von 10 mm. Die resultierende Fleckgrösse ist etwa 2 Mikrometer und die Schärfentiefe ist etwa 1,3 Mikrometer. Der Umlenkspiegel kann steuerbar oder justierbar angeordnet sein.

Das Tastlasergerät 23 ist in diesem Beispiel ein He-Ne Laser von 1 mW Leistung und 0,65 mm Strahldurchmesser. Dieser wird mit einem Aufweiter 24 auf das 4-fache vergrössert und mit einem justierbaren Umlenkspiegel dem Schreiblaserstrahl überlagert.

## Ansprüche

1. Anordnung auf einem Chip (1) zur Positionierung und Synchronisation eines Schreiblaserstrahls (21) auf dem Chip (1) bei einem Laserschreibverfahren mittels eines Laser-Patern-Generators, wobei im Randbereich des Chips auf des Oberfläche Erkennungsmuter für einen Tastlaserstrahl vorgesehen sind, die den Tastlaserstrahl (23') in bezug auf andere Teile der Oberfläche des Chips unterschiedlich stark reflektieren, dadurch gekennzeichnet, dass sich entlang von wenigstens zwei Rändern des Chips (1) auf der Oberfläche eines erster das Erkennungsmuster Eintrittscodes (4, 4') mit einer Synschronisationsstruktur (5) und einer Schritterkennungsstruktur (6) erstreckt.

2. Anordnung nach Anspruch 1, dadurch gekennzeichnet, dass sich auf der Oberfläche des Chips senkrecht zu der Längsrichtung des ersten Eintrittscodes (4) das Erkennunsgmuster eines Einfädelcodes (7, 7') in der Richtung zu einer Ecke (14) eines Rahmens (11, 11') mit einer Logik (12) erstreckt.

3. Anordnung nach Anspruch 2, dadurch gekennzeichnet, wenigstem zwei Seiten der die Logik (12) umfassende Rahmens (11, 11') mit dem Erkennungsmuster eines zweiten Eintrittscodes (13, 13') versehen sind.

4. Anordnung nach Anspruch 3, dadurch gekennzeichnet, dass sich des der Erkennungsmuster Eintrittscodes (13, 13') auf der äusseren Randzone des Rahmens (11, 11') parallel mit dem Erkennungsmuster der entsprechenden ersten Eintrittscode (4, 4') erstreckt.

## Claims

1. An arrangement on a chip (1) for positioning and synchronising a writing laser beam (21) on the chip (1) in a laser writing method by means of a laser pattern generator, wherein recognition patterns for a scanning laser beam are provided in the edge region of the chip (1) on the surface, which recognition patterns reflect the scanning laser beam (23') to a greater or lesser extent in relation to other parts of the surface of the chip, characterised in that the recognition pattern of a first entry code (4, 4') with a synchronisation structure (5) and a step recognition structure (6) extends along at least two edges of the chip (1) on the surface.

2. An arrangement according to claim 1, characterised in that on the surface of the chip perpendicular to the longitudinal direction of the first entry code (4), the recognition pattern of a thread code (7, 7') extends in the direction of a corner (14) of a frame (11, 11') with a logic (12).

3. An arrangement according to claim 2, characterised in that at least two sides of the frame (11, 11') containing the logic (12) are provided with the recognition pattern of a second entry code (13, 13').

4. An arrangement according to claim 3, characterised in that the recognition pattern of the second entry code (13, 13') on the outer edge zone of the frame (11, 11') extends parallel to the recognition pattern of the corresponding first entry code (4, 4').

## Revendications

1. Arrangement sur une puce (1) pour le positionnement et la synchronisation d'un rayon laser d'écriture (21) sur la puce (1) dans un procédé d'écriture à laser au moyen d'un générateur de caractères à laser, des modèles d'identification étant prévus sur la surface, dans la zone marginale de la puce (1), pour un rayon laser d'exploration lesquels provoquent une réflexion variable du rayon laser d'exploration (23') par rapport à d'autres parties de la surface de la puce, caractérisé en ce que le signe d'identification d'un premier code d'entrés (4, 4') avec une structure de synchronisation (5) et une structure d'identification de pas (6) s'étend le long d'au moins deux bords de la puce (1), sur la surface de celle-ci

2. Arrangement selon la revendication 1, caractérisé en ce que, sur la surface de la puce et perpendiculairement à la direction longitudinale du premier code d'entrée (4), le signe d'identification d'un code d'enfilement (7, 7') s'étend en direction d'un des coins (14) d'un cadre (11, 11') avec une logique (12).

3. Arrangement selon la revendication 2, caractérisé en ce qu'au moins deux côtés du cadre (11, 11') comprenant la logique (12) sont munis du signe d'identification d'un second code d'entrée (13, 13').

4. Arrangement selon la revendication 3, caractérisé en ce que le signe d'identification du second code d'entrée (13, 13') dans la zone extérieure du bord du cadre (11, 11') s'étend parallèlement au signe d'identification du premier code d'entrée (4, 4') correspondant.

FIG.1

FIG.2

FIG.3

FIG.4

FIG.5a

FIG.5b